# EUROPEAN PATENT SPECIFICATION

(11) **EP 0 393 251 B1**
(45) Date of publication and mention of the grant of the patent: **05.07.1995**
(21) Application number: 89200986.1
(22) Date of filing: 17.04.1989
(51) Int. Cl.: H01R 23/70, H01R 13/514

(54) **Modular connector system with high contact element density surface mounted connectors**
Modulares Verbindersystem mit oberflächenmontierten Verbindern hoher Kontaktelementdichte
Système connexion modulaire, avec connecteurs montés en surface à haute densité des éléments de contact

(43) Date of publication of application: 24.10.1990
(60) Divisional application: 94203022.2
(73) Proprietor: CONNECTOR SYSTEMS TECHNOLOGY N.V., Willemstad, Curaçao (AN); DU PONT DE NEMOURS (NEDERLAND) B.V., Dordrecht (NL)
(72) Inventor: Verhoeven, Laurentius Maria, NL-5465 RV Veghel (NL)
(74) Representative: de Bruijn, Leendert C.

(56) References cited:
- WO-A-86/01644
- DE-A- 3 016 509
- DE-A- 3 620 111
- DE-B- 2 005 521
- FR-A- 1 582 222
- US-A- 3 426 311
- US-A- 3 689 865
- US-A- 3 895 267
- US-A- 3 958 852
- US-A- 4 138 179
- US-A- 4 343 528
- US-A- 4 392 705
- US-A- 4 410 222
- US-A- 4 580 858
- US-A- 4 698 906
- US-A- 4 702 707

## Description

### Background of the Invention

The present invention relates to a connector system comprising a connector and at least one protective plate, the connector being suitable for mounting to a printed circuit board comprising a housing of electrically insulative material, a plurality of contact elements arranged in said housing in rows and columns, said rows disposed substantially parallel to the circuit board and said column disposed substantially transverse to the circuit board, each of said contact elements having a base section with a contact portion and a connecting portion extending from opposite sides of said base section, the connecting portion projecting from one side of the housing facing the circuit board and adapted for mounting to contact surfaces on said circuit board, the connecting portions of adjacent contact elements in the same column being displaced in the direction of the row so as to contact surfaces on said printed circuit board offset relative to one another.

A connector module generally comprises a housing of electrically insulative material which accommodates a plurality of contact elements or terminals arranged in rows and columns. The contact elements have a base section and a contact end and connecting end extending from opposite ends of the base section. The connecting ends project outside one side of the housing and are connected to a printed circuit board.

There have long been attempts to accommodate electronic circuits in as modular a design as possible on printed circuit boards of standard dimensions. The interconnections between the individual modules and components, such as recorders, playback devices, etc., are preferably made via electronic connectors. As a consequence of miniaturization and due to the high density of present day integrated circuits, a large number of electronic components can be mounted on a printed circuit board so that a large number of functions can be carried out by a module of this type. The number of terminals needed for connection to other modules has, likewise, increased.

As a result, there is a great need for connectors with a high contact element density, i.e., with a large number of electrical contacts or terminals per unit of volume. The need for connectors with high contact element density has become even greater as a result of the advent of surface mounting technology whereby electronic components are surface mounted to the printed circuit board. Surface mounted devices (SMD) are not mounted on a printed circuit board via the usual pinhole connection but are connected directly to the surface of the printed circuit itself. By surface mounting techniques, it is possible to mount electronic components readily on either surface of a board without interfering with connecting pins which project through the board. This results in a component density which is even higher than that achieved with conventional pinhole connections and a further increase in the number of terminals.

In many cases the contact element density of a connector cannot be increased simply placing the contact elements closer together or by forming several rows of contact elements located above one another. Generally, this results in an undesirable mutual electrical interference between the contact elements, essentially as a consequence of capacitive couplings between them. Furthermore, it is not possible in a connector to use an unlimited number of rows located above each other because contact elements with very long connecting ends to the printed circuit board will increase problems due to the occurrence of undesired inductive couplings and the circuit becomes more sensitive to electromagnetic noise signals.

It is furthermore necessary to maintain a defined minimum distance between the individual contact elements because the wall thickness of the housing in which the contact elements are accommodated must not become too thin in order to meet specified strength requirements. Moreover, from the viewpoint of mechanical strength of the printed circuit board, it is not desirable to connect several rows of contact elements to only one of its sides because with such an asymmetric arrangement, the board will tend to bulge in the center of the connector. This will result in an undesired force being applied to the board which may cause breaks in the thin printed circuit strips on the board.

A connector system according to the preamble of claim 1 is known from US-A-4.392.705 which discloses a connector system for electrically connecting a circuit card to a circuit board. In one embodiment of the known connector system a housing comprises several contact elements arranged in rows and columns, wherein the connecting portions of adjacent contact elements in the same column are displaced in the direction of the row so as to contact surfaces on said printed circuit board offset relative to one another. Moreover, the embodiment referred to shows four separate contact elements in each column, two of the connecting portions of those four contact elements being connected to one side of the printed circuit board and the remaining two contact elements being connected to the other side of the printed circuit board. No protective means to protect electrical components on the circuit board are provided.

US-A-3.895.267 discloses the application of protective plates in connector systems. Two electrically conductive protective plates both provided with raised side edges are shown, which are fixed together by means of bolts, while a printed circuit board carrying electrical components is located in between them and entirely shielded.

### Summary of the Invention

The object of the present invention is to provide a connector system provided with at least one protective plate in order to protect electrical components on the printed circuit board.

Therefore, the connector system according to the invention is characterized in that said one side of the housing comprises at least one row of openings and in that the connector system comprises at least one protective plate comprising teeth disposed along at least one of its edges, said teeth being adapted for insertion in said one row of openings in the housing of the connector so that when assembled and connected to the printed circuit board, the protective plate extends parallel to the said printed circuit board.

In a first embodiment said teeth are formed on an elongated rail of electrically insulating material, said rail being disposed near said edge of the protective plate, the teeth being disposed at a distance from the surface of the protective plate.

Said protective plate may extend on both sides of the elongated rail, whereas it may further comprise openings formed in the plane of the plate, said openings being adapted to secure the protective plate to the printed circuit board.

The connector of the invention may in one embodiment have connecting ends which are inclined in the direction of an imaginary plane extending transversely to and in the longitudinal direction of side of of the housing for connecting the printed circuit board which is to be mounted in this plane on one or both sides.

In accordance with another embodiment, the connecting ends possess, near their free extremities, a flat portion for surface mounting to a printed circuit board according to the above. In yet another embodiment of the connector, the free extremities of the connecting ends are bent backwards relative to the imaginary plane in order to form a funnel which can readily receive the printed circuit board. A still further embodiment of the connector according to the invention has two rows of contact elements which are located on either side of the imaginary plane.

In order to keep the capacitive interference between adjoining contact elements as small as possible, the base section of the contact elements has to be designed so as to be flat, as shown in Figure 11 of the above US-A-4.392.705. A further embodiment of the connector according to the present invention has contact elements which are arranged in four rows and the connecting ends are designed as flat connecting tongues which form an integral part with the base section. The respective connecting tongues are located near an edge of the base section. In yet a further embodiment of the connector, the free extremities of the connecting tongues of adjoining contact elements in a column extend on one side of the imaginary plane over various distances from the housing in the plug-on direction of the connector.

As a result of the above-described displaced arrangement of the connecting ends in the plug-on direction of the connector, the respective connecting surfaces on the printed circuit board may also be arranged mutually displaced with respect to the edge of the board at the plug-on side. This is in contrast to connecting surfaces which must be arranged next to each other as in the case of connectors with terminals having connecting ends which terminate at the same distances. In comparison with connecting surfaces arranged next to one another, for a given pitch distance, the above-mentioned displaced arrangement of the connecting surfaces permits not only wider connecting surfaces, wider connecting ends and/or wider flat parts of the contact elements for connection thereof with the consequent associated greater mechanical strength, but inter alia, also increases the reliability during soldering of the connecting ends. Because the connecting surfaces are separated from one another by a relatively large distance, the risk of undesirable connections is thereby smaller than in the case of surfaces arranged next to one another. The smaller the pitch distance becomes and/or the larger the total contact element density of the connector becomes (several rows), the greater the advantage in the displaced arrangement in the plug-on direction of the connecting ends of the contact elements.

The contact elements of the invention are also fairly simple to manufacture. The contact elements have two separate connecting tongues, one of which is removed in the final assembled state in order to achieve the mutual displacement of the connecting ends of the adjoining contact elements.

Where surface mounting is employed, the displaced arrangement of the connecting ends in the longitudinal direction of the connector housing has the further advantage that the flat portions of the respective connecting ends do not slide during mounting over their respective connecting surface on the printed circuit board. This prevents soldering paste or electrically conductive adhesive which may be present on these connecting surfaces from being removed during fitting of the connector on the printed circuit board.

As a result of the flat design of the base section, a still further embodiment of a connector module according to the invention may have a housing wall thickness on the end faces which is smaller than or equal to half the pitch distance between the contact elements, arranged so as to adjoin each other in a row. The connectors designed in this way can be mounted with the end edges up against each other without losing space for a column of contact elements. This is particularly advantageous in the case of printed circuit boards requiring connectors with a high contact element density.

In this application, the term "printed circuit board", which is also commonly referred to as "printing wiring board", is understood as meaning, in general, substrates with conducting tracks and thus, for example, also substrates of liquid crystal displays.

In the text which follows, the invention will be illustrated in detail by reference to drawings of preferred embodiments of a connector by surface mounting techniques, including among others a protective plate.

### Brief Description of the Drawings

Figure 1 shows diagrammatically in perspective two different embodiments of contact elements according to the invention which are connected on either side to a printed circuit board;
Figure 2 shows diagrammatically in perspective partially cut-away embodiments of a connector according to the invention, with the contact elements according to Figure 1;
Figure 3 shows, on an enlarged scale, a partial longitudinal section along the Line III-III through the connector shown on the left-hand side of Figure 2, in which the contact elements are connected with their connecting ends to a carrier strip;
Figure 4 shows, on an enlarged scale, the section through the connector shown on the left-hand side of Figure 2;
Figure 5 shows, on an enlarged scale, a rear view of the connector shown on the left-hand side of Figure 2, the left half of which is shown provided with contact elements;
Figure 6 shows diagrammatically in perspective a number of connectors, mounted next to each other, for surface mounting according to the invention;
Figure 7 shows, in perspective, a partial diagram of an unassembled protective plate provided with teeth and shows, in a partially cut-away view, a protective plate connected to two connectors according to the invention;
Figure 8 shows diagrammatically in perspective several protective plates located next to each other and on either side above a printed wiring board, which protective plates are fixed in accordance with Figure 7 to a number of connectors mounted next to each other, as shown in Figure 6;
Figure 9 shows diagrammatically in perspective two cable connectors located opposite each other for a ribbon cable which can be connected to a four-row connector according to the invention;
Figure 10 shows diagrammatically in perspective power and coaxial connectors connected surface mounted to a printed wiring board.

### Detailed Description of the Embodiments

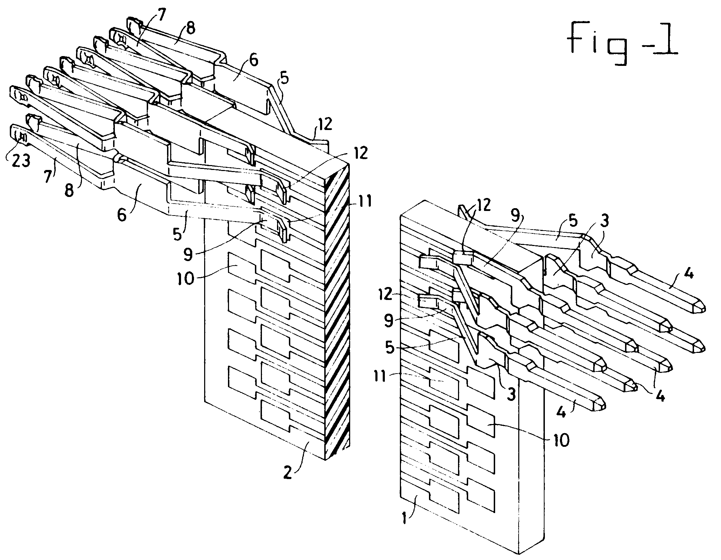

Figure 1 shows diagrammatically in perspective two embodiments of contact elements of electrically conducting material, located on either side of a printed circuit board 1,2 with connecting ends arranged for surface mounting to the board. The printed circuit board 1,2 is essentially located in the middle between four rows of contact elements arranged in columns, only two elements in each row being shown in Figure 1.

In the case of the contact elements shown on the right-hand side of Figure 1, a contact pin 4 and a flat connecting tongue 5, respectively, extend in opposite direction from a flat base section 3. In the case of the contact elements shown on the left-hand side of Figure 1, contact lingers 7,8 extend in one direction and a flat connecting tongue 5 extends in the other, opposite direction from a flat base section 6.

As can be seen in Figure 1, the connecting tongues 5 of the various contact elements are arranged so that they adjoin each other in a column and are connected to the printed circuit board 1,2 so as to be mutually displaced in the longitudinal direction. The connecting tongues are inclined in the direction of the printed circuit board 1,2 and extend from an edge of the flat base section 3 or 6. The connecting tongues 5 have, near their free extremity, a flat portion 9 located parallel to the board 1,2 for surface mounting to connecting surfaces 10,11 on the printed wiring board 1,2. Connecting surfaces 10 are arranged in one row nearer to the edge at either side of the board while connecting surfaces 11 are also arranged in a row further from the edge of each side of the board. The contact elements of the innermost rows are situated directly adjacent to the printed circuit board 1,2, the flat portion 9 of these contacts units are situated virtually in the plane clamped by the respective flat base sections 3,6. The flat portion 9 of the contact elements actually merges smoothly into the connecting tongue 5 of these contact elements. The connecting tongues 5 do not always have to be flat, however, but may, for example, also have a round, elliptical or polygonal cross-section and/or may be narrower than the flat portion 9 for connecting to the connecting surfaces 10,11 of the printed circuit board 1,2. The connecting tongues 5 further have a free extremity 12 which is bent backwards at an angle relative to the printed circuit board 1,2.

In Figure 1, the connecting tongues 5 located on each side of the printed circuit board 1,2 are connected to connecting surfaces 10,11 lying displaced in the plug-on direction of the connector, transversely to the board 1,2. In other words as noted above, surfaces 10 are arranged in 6 rows nearer the edge of each side while surfaces 11 are also arranged in a row further from each edge. In this arrangement, the center elements of the innermost rows described above contact surfaces 10. The outer row of contact elements elements have connecting tongues more inclined to their respective base sections 3,6 and the board 1,2 and contact surfaces 11 on either side of the board. It is, however, also possible to connect the flat portions 9 for surface mounting/connection of the connecting tongues at an equal distance from the edge of the printed circuit board 1,2 in which case the connecting tongues 5 and the connecting surfaces 10, 11 then lying next to each other should have suitable dimensions in order to avoid undesired electrical contact. With one and the same pitch distance, however, it is possible, as a consequence of arranging the ends of the connecting tongues 5 of adjacent contact elements, as shown so as to project over different distances from the housing in the plug-on direction of the connector to use relatively wider connecting surfaces 10,11 than in the case where the connecting tongues extend over an equal distance from the housing where connecting surfaces 10,11 on the printed circuit board are situated next to each other, i.e., in the same row. wider connecting surfaces or wider connecting tongues 5 and/or wider flat sections 9 thereof mean not only a mechanically stronger connection to the printed circuit board, but also a more reliable solder joints. Because the soldered surfaces are relatively far removed from each other in the case of the displaced arrangement shown of the connecting surfaces 10,11, the risk of undesirable solder connections is in this case less than in the case of connecting surfaces 10,11 situated next to each other in a row. As the pitch distance of the contact elements decreases, there is an increasingly greater advantage in the displaced arrangement of the connecting surfaces.

In the preferred embodiment shown in Figure 1, the connecting tongues 5 of the respective contact elements extend in each case from the edge of the respective flat base section 3,6 and form an integral part therewith. It will be clear that the connecting tongues 5 can also be arranged so as to be displaced relative to the edge of each flat base section 3,6 and can also extend, for example, from the center thereof. Contact elements with connecting ends mating sideways and in the middle of the base section can then be used, as shown in Figure 1, for connectors consisting of six rows of contact elements, i.e., three on either side of the board 1,2.

It is, of course, not essential that the printed circuit board 1,2, as mentioned earlier, be disposed in the middle between the rows of contact elements. the connecting ends can be arranged in such a way that, for example, three rows of contact elements can be located with the respective connecting ends on one side of the printed circuit board 1,2 and, for example, only one or two rows on the other side, according to the positioning of the connecting ends. Furthermore, it is also not essential that the contact elements be connected on both sides of the printed wiring board, although such a symmetrical arrangement is preferable in the case of connectors with a large number of contact elements because of the warping of the board and the risk of tearing of the thin conducting racks on the board.

As a result of the mutually displaced arrangement of the connecting tongues 5, the flat portions 9 alone slide over only those connecting surfaces 10,11 on which they are connected so that any solder or adhesive paste present on these connecting surfaces is not damaged or pushed away by a connecting tongue other than that to be connected to a corresponding connecting surface sliding over it. The contact surfaces 10,11 may, of course, have another suitable shape for connecting the contact elements which differs from the rectangular shape shown.

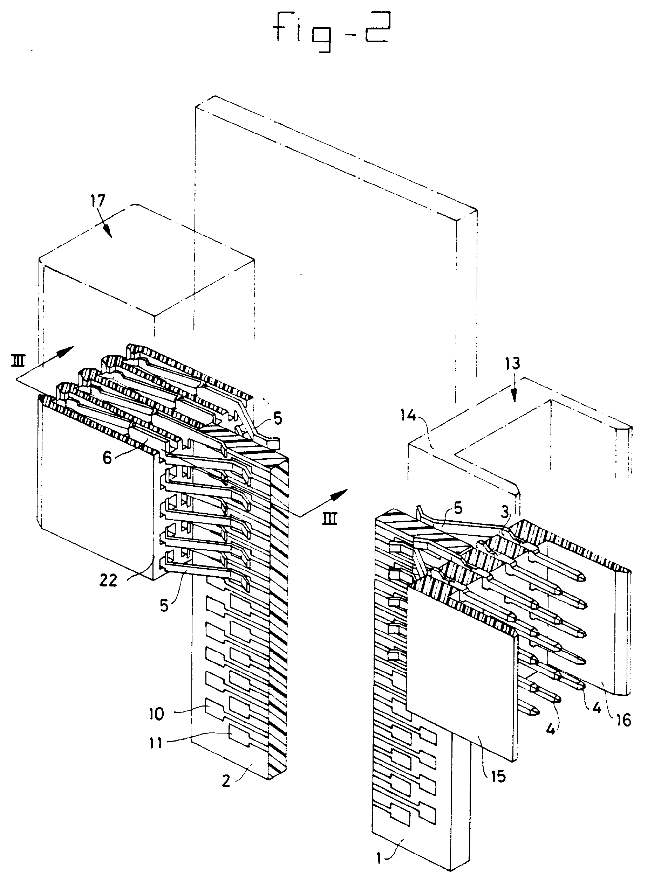

Figure 2 shows diagrammatically in perspective and impartially cut-away form two embodiments of a connector module according to the invention in which the contact elements of Figure 1 are used. The connector housing 13, shown on the right-hand side of Figure 2, the contact ends of the contact elements are designed as contact pins 4 is open on the side facing away from the printed wiring board 1. The contact pins are fastened in the rear wall 14 of the housing 13 which is arranged against the edge of the board. The side walls 15,16 of the connector 13 have a mutual distance such that a connector 17 shown on the left-hand side of Figure 2 can, for example, be arranged therebetween with the contract fingers 7,8 making electrical contact with the contact pins 4. The contact elements shown on the left-hand side of Figure 1 are fixed in the rear wall 22 of this connector 17.

As can be seen in Figure 2, the narrow edges of the flat base section 3,6 of the contact elements, arranged so as to adjoin each other in a row, are located opposite each other while the broad surfaces of the flat base sections 3,6 of the contact elements, arranged so as to adjoin each other in a column, are located opposite each other. As is known, the capacitive interference between two adjoining contact elements is directly proportional to the surface of the broad sections lying opposite each other and is inversely proportional to the distance therebetween while the distance between the contact elements arranged in Figure 2 so as to adjoin each other in a row is relatively small, thus implying a large capacitive coupling therebetween the fact that the narrow edges of the flat base sections 3,6 are the surfaces opposite each other results in relatively small capacitance. The converse applies to the contact elements arranged so as to adjoin each other in a column. There the broad surface of the base sections 3,6 are located opposite each other is in fact now relatively large but because the distance therebetween as a result of the illustrated sitting of the contact elements is also relatively large, the resulting capacitive interference remains small. The connecting tongues 5 themselves may be connected, as shown, directly to the printed circuit board 1,2 and may be relatively short, which is an advantage in connection with the sensitivity to electro-magnetic interference and inductive couplings between the respective connecting tongues.

As a result of the above-described arrangement, the usual minimum pitch distance of 2.54 mm between the contact elements adjoining each other in rows and columns can then be advantageously reduced to 2 mm or less. This results in a considerable space saving, in particular in the case of connectors with a large number of contact elements, thus achieving a higher contact element density in a connector of given dimensions.

Figure 3 shows, on an enlarged scale, a partial section along the Line III-III in the longitudinal direction of the connector 17 shown in Figure 2 and connected to the printed circuit board 2. This connector has, on the front side 18 facing away from the printed wiring board, openings 19 which expand towards the outside and in which a contact pin can be inserted for contacting the resilient contact fingers 7,8 extending from the flat base section 6. Figure 3 also shows that the contact elements can all be manufactured in the same way; namely, by manufacturing them with the two connecting tongues 5 connected to a carrier strip 21. During assembly of the connector, one connecting tongue is subsequent removed, the other connecting tongue is brought to the required length and the flat section 9 and the bend 12 are formed. It will be clear that such a universal contact element offers great advantages during assembly of a mass-produced article such as a connector.

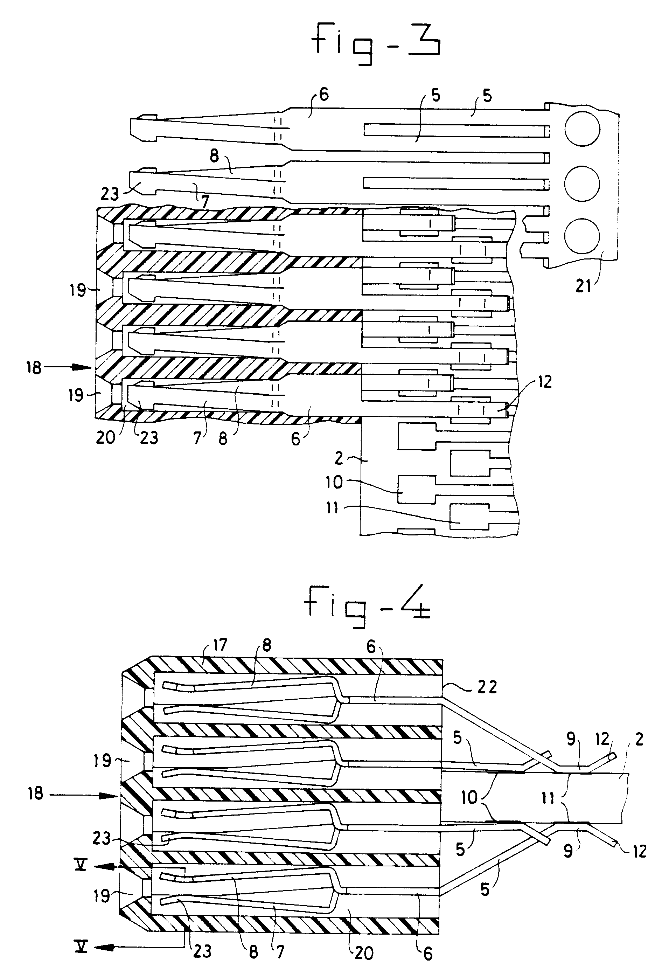

Figure 4 shows, on an enlarged scale, the cross-section through the connector 17 shown in Figure 2. The contact fingers 7,8 are bent, on the extremity connected to the base section 6, over a section of their length in opposite direction out of the plane of the base section 6. The two contact fingers 7,8 are bent towards each other again at the end of this section and the contact surfaces 23 are located at the free extremities lying above each other (see also Figure 3). In order to prevent displacement in the longitudinal direction of the contact elements and to influence the 4 contact properties of the contact fingers, raised portions and guides (none shown) may be fitted in the channel 20 of the connector 17. The sections of the contact fingers 7,8 bent out of the plane of the base section 6 may rest against these raised portions and guides.

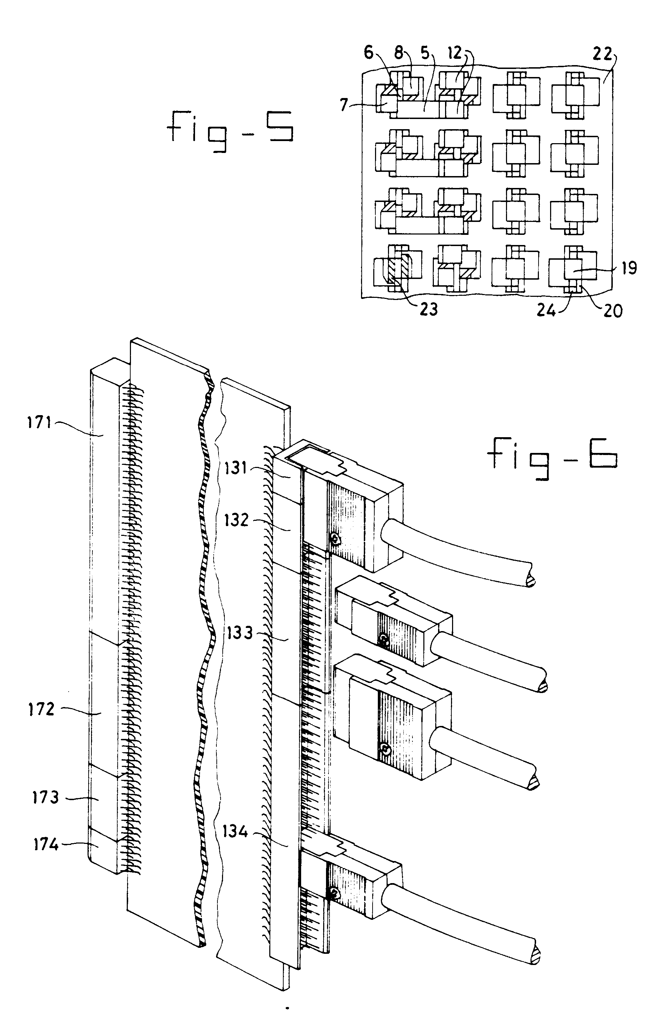

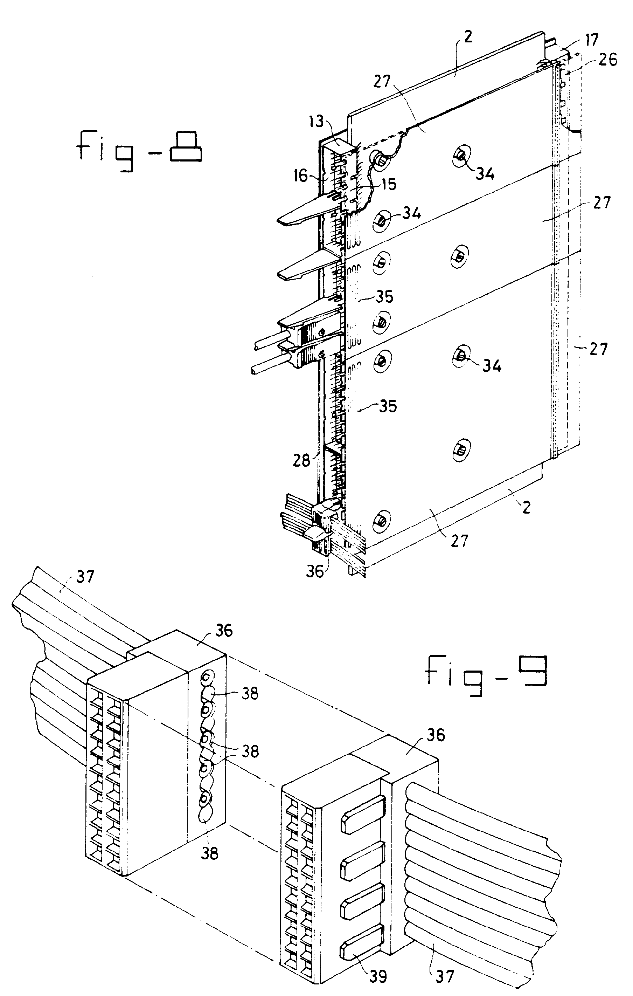

Figure 5 shows, on an enlarged scale, a view facing the rear wall 22 of the connector 17 in Figure 2 in which the connecting tongues 5 project to the outside. For the sake of simplicity only, the left-hand two rows are provided with contact elements in the drawing. The flat base sections 6 of the contact elements are clamped in slits 24 in the rear wall 22 of the connector. At the bottom left in Figure 5, differing from the other views, a section along the line V-V in Figure 4 is shown for one contact element, the hatched sections being the contact surfaces 23 of the contact iingers 7,8 (see also Figure 1). The contact surfaces 23 may be made flat or curved.

As can be clearly seen from Figure 5, the slits 24 for receiving the flat base sections 6 or 3 are situated in the center of the channels 20. As a result, the capacitance between adjacent contact elements has the same low value over the whole connector. This arrangement of contact elements is possible as a consequence of the fact that the contact fingers 7,8 are bent in the opposite direction out of the plane of the flat base section 6.

The contact pins 4 in a column of the connector 13 shown on the right-hand side of Figure 2 may be of mutually different lengths (not shown). The longest contact pin, for example, can be used for grounding purposes, the next shortest contact pin for providing the supply voltage and the other still shorter contact pins can, for example, be used for signal paths. These last mentioned contact pins may be of equal length. On contacting a connector constructed in this manner, contact is first made with the ground contact pin, then with the supply contact pin and then with the signal contact pins. This advantageously ensures that the apparatus is always connected first to ground so that any fault currents as a result of short circuits or static charge and the like can flow away directly. The contact pins 4 may also have a section differing from the rectangular shape shown, such as, for example, a truncated elliptical form.

Figure 6 shows a row of the connector modules 131-134, 171-174 of varying lengths constructed according to the invention. As is clearly visible, long rows of connector modules can be formed without loss of space for a contact element. To permit this, however, the wall thickness at the end faces of the connectors 13,17 shown in Figure 2 is smaller than or equal to half the pitch; that is to say, the distance between two adjoining contact elements in a row.

The invention is described above by reference to preferred embodiments of symmetrical connectors which are surface mounted. It should be clear that the arrangement of the connecting ends of the contact elements according to the invention can also be used connectors with conventional pin/hole connections in connectors with so called wire-wrap connections, in which case the connecting ends are pins projecting to the outside.

The contact elements may advantageously be made of flat spring material. The housing of the connector may be made of thermoplastic polyester resin, such as "Rynite" FR-530 produced by the Du Pont Company. This material makes possible to construct a connector with a smaller wall thickeners which is resistant to the higher temperatures which may arise in vapor phase soldering (VPS) while maintaining mechanical strength and breaking resistance.

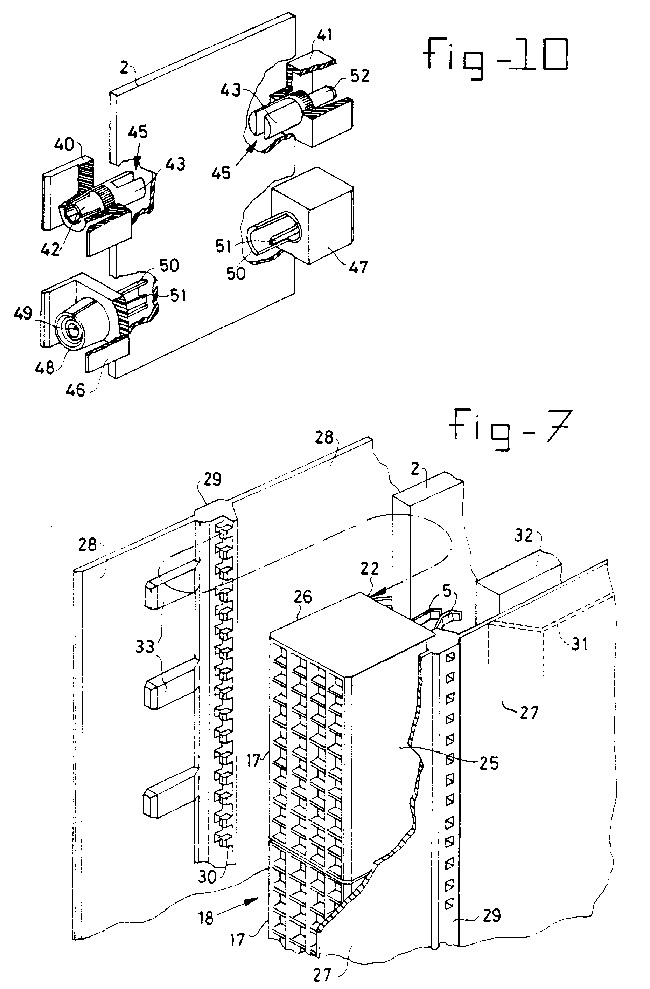

Figure 7 shows, in perspective, a partial diagram of two connector modules 17 which are connected mounted one above the other to a printed wiring board 2. A protective plate 27 is shown on the right-hand side of the connectors 17, viewed from the contact openings thereof. The protective plate 27 is located parallel to the right-hand sidewalls 25 of the connectors 17 at a distance above the printed circuit board 2. The portion of the protective plate 27 situated opposite the right-hand sidewall 25 extends beyond the connectors 17 and is shown partially cut-away. The protective 27 is further provided with an elongated rail 29. A similar protective plate 28 having rail 29 is shown parallel to the left-hand sidewall 26 of the connectors 17.

The rail 29 is provided with teeth 30 projecting parallel to the plane of the respective protective plates 27,28 in the direction of the front 18 of the connector 17. The teeth 30 are mutually insulated electrically relative to each other and relative to the protective plate. For this purpose, the rail 29 can advantageously be made of a plastic by means of, for example, an injection moulding technique.

As indicated by a broken-line arrow in Figure 7, the teeth 30 have to be inserted in the connectors 17 on the rear side 22. The mutual distance between the teeth 30 and the dimensions thereof are such that they can be received adjacent to the base sections 6 of the contact elements of the outermost rows of the connectors 17 in the channels 20 shown in Figure 4. Other suitable openings for receiving the teeth 30 may also be disposed in the rear wall 22 in a manner such that in the assembled state the protective plate extends parallel to the printed circuit board, as shown in Figure 7.

For mechanical protection of the electronic components fitted to the printed circuit board 2 (which are indicated by 32 in Figure 7), the protective plates 27,28 may be manufactured from a suitable plastic material. In order to obtain good electrical screening, the protective plates may be manufactured from electrically conductive material or form, for example, plastic with an electrically conductive layer applied thereupon. The protective plates can also comprise several plate sections connected together, if necessary.

As also shown in Figure 7 with broken lines 31, it is not necessary for the protective plates to extend over their entire surface in the same plane but they may also be designed such that they partially extend at a greater or partially at a smaller distance above the printed wiring board 2. To prevent errors as much as possible during contacting of the connectors 17, or to avoid erroneous connections being made, positioning projections 33 which may be broken away are formed on the rail 29.

Figure 8 shows a printed circuit board 2 with connectors according to the invention fitted on opposite sides. Several protective plates 27,28 of different dimensions are mounted on the two flat sides of the printed wiring board 2. Openings 34 are formed in the protective plates 27 in a manner such that the protective plates can be mechanically connected to the printed circuit board 2 by means of, for example, screws and spacers. This results in the desired strong mechanical connection between the diverse connectors and the printed wiring board. At the position of the sidewalls 15,16 of the connectors 13, the protective plates are provided with ribs 35 extending in the longitudinal direction of the connectors 13. This increases the mechanical stability of the protective plates and prevents the protective plates from being bent during rough contact of the connectors 13. It should be clear that ribs 35 extending in the transverse direction (not shown) across the protective plates may also be provided with the same object.

As mentioned earlier, it may be necessary, particularly in elaborate systems, to connect parts of one connector with parts of another connector or with another printed circuit board. At the bottom left in Figure 8, four adjoining cable connectors 36 of the type illustrated in Figure 9 are shown mounted to the connector 13. The cable connectors 36 adjoin each other in Figure 8 without loss of space for one or more contact elements.

In Figure 9, two cable connector modules having a housing 36 with two rows of contact openings located opposite each other at a distance are shown diagrammatically in perspective on an enlarged scale. The ribbon cables 37 have conductors disposed opposite each other in the open channels 38 of the respective cable connectors. The channels extend in the column direction of the contact elements from one side of the housing to the other. To prevent these conductors making undesired electrical contact with each other, the contact elements of the cable connectors 36 are so arranged that only one connecting end of a contact element is situated in each channel 38 so that, if two ribbon cable connectors are positioned opposite each other, the respective contact elements in the same column are separated from each other over at least a distance of one position. By further providing that the end of a ribbon cable 37 to be received in a cable connector has a course corresponding to the siting of the connecting ends of the contact elements so that after assembly of the ribbon cable, the conductors of the contacting extremities do not project beyond the housing 36, the ends of the contacted conductors will then not touch each other when the cable connectors are mounted opposite each other.

The contact elements can, of course, be arranged in different ways. For example, adjoining contact elements of a two-row cable connector with an even number of columns can each be located in a different row with the end of the ribbon cable 37 to be received in the cable connector having a castellated course. As mentioned above, the contact elements may have a flat base section from which contact iingers or a contact pin extend with the connecting end being designed as a plug-on contact (not shown). The pitch distance between the contact elements is preferably 2 mm. In Figure 9, similarly to Figure 7, projections 39, which can be broken away, are attached to avoid erroneous contacting.

Figure 10 shows diagrammatically in perspective and in partially cut-away view, power connectors 40,41 and coaxial connectors 46,47 for connecting by surface mounting feed cables and coaxial cables to a printed circuit board. Connectors previously described are less suitable for connecting feed cables carrying a relatively large current.

The unipolar power connector 40 is essentially constructed from a contact socket 42 of electrically conducting material having a spring-loaded contact end for receiving a contact pin and an elongated socket-shaped connecting end 43 for connection to a printed wiring board. the power connector 41 has a pin-shaped contact end 52 and a similar socket-shaped connecting end 43. In order to make it possible to connect the connecting end to a printed circuit board by surface mounting, the elongate connecting end 43 is provided, according to the invention, with a slot-shaped recess 45 in which the printed circuit board 2 may be received so that the connecting end 43 can be connected to the printed circuit board 2 at the two opposite flat sides thereof.

For connecting coaxial plugs, coaxial connectors 46,47 are used in practice. These connectors have an elongated outermost contact socket 48 and innermost contact socket 49 which are electrically insulated from each other and respectively an outermost contact socket and an innermost contact pin (not shown) of electrically conducting material.

To permit surface mounting of the coaxial connectors to a printed circuit board, a part of the connecting end of the outermost contact socket 48 is removed from the circumference so that the remaining, virtually semicylindrical connecting end 50 can be connected to one side of the printed circuit board 2. Part of the jacket of the innermost contact socket 49, or the innermost contact pin, is removed so that the remaining connecting tongue 51 can be connected to the other side of the printed circuit board 2.

The connectors designed in this manner possess sufficient mechanical stability and a sufficiently large contact surface so that reliable and mechanically stable connections with a printed circuit board can be made by surface mounting technique. In practice, of course, it is possible, as a departure from the embodiments shown in Figure 10, for several coaxial connectors and/or several power connectors to be accommodated in a single module housing.

It will be clear that the invention is not limited to the preferred embodiments thereof described and shown in the drawings, but that other variations and modifications are possible. For example, the connector modules may include optoelectronic connectors connected to optical fiber cables, shielded connectors, to locking means or so called polarity indicators to prevent incorrect connection of the connector modules, etc., all without deviating from the scope of the invention which is defined by the claims.

## Claims

1. Connector system comprising a connector (17) and at least one protective plate (27, 28), the connector (17) being suitable for mounting to a printed circuit board (1, 2) comprising a housing (13) of electrically insulative material, a plurality of contact elements arranged in said housing (13) in rows and columns, said rows disposed substantially parallel to the circuit board (1, 2) and said column disposed substantially transverse to the circuit board, each of said contact elements having a base section (3; 6) with a contact portion (4; 7, 8) and a connecting portion (5) extending from opposite sides of said base section, the connecting portion (5) projecting from one side (22) of the housing (13) facing the circuit board and adapted for mounting to contact surfaces (10, 11) on said circuit board, the connecting portions of adjacent contact elements in the same column being displaced in the direction of the row so as to contact surfaces on said printed circuit board offset relative to one another characterized in that said one side (22) of the housing (13) comprises at least one row of openings and in that the connector system comprises at least one protective plate (27, 28) comprising teeth (30) disposed along at least one of its edges, said teeth being adapted for insertion in said one row of openings in the housing (13) of the connector so that when assembled and connected to the printed circuit board, the protective plate (27, 28) extends parallel to the said printed circuit board.

2. Connector system according to claim 1 characterized in that said teeth (30) are formed on an elongated rail (29) of electrically insulating material, said rail being disposed near said edge of the protective plate (27, 28), the teeth being disposed at a distance from the surface of the protective plate.

3. Connector system according to claim 2 characterized in that said protective plate (27, 28) extends on both sides of the elongated rail (29).

4. Connector system according to any of the preceding claims characterized in that said protective plate (27, 28) further comprises openings (34) formed in the plane of the plate, said openings being adapted to secure the protective plate to the printed circuit board (1, 2).

5. Connector system according to any of the preceding claims characterized in that the connecting portions (5) of said contact elements are inclined in the direction of a plane extending transversely to said one side (22) of the housing (13) in the lengthwise direction thereof, said connecting portions (5) being able to contact either one or both sides of the printed circuit board (1, 2) disposed in the plane.

6. Connector system according to claim 5 characterized in that each connecting portion (5) has near its free end a flat portion (9) lying parallel to said plane to permit surface mounting to the printed circuit board (1, 2).

7. Connector system according to claim 6 characterized in that the free end (12) of each connecting portion (5) is bent backwards relative to said plane in order to form a funnel for readily receiving the printed circuit board (1, 2).

8. Connector system according to claim 5 characterized in that the contact elements are arranged in four rows, two of said rows of contact elements being disposed on one side of said plane and two of said rows being disposed on said other side of said plane, the connecting portions (5) of adjacent contact elements in the same column being mutually displaced on each side of the plane.

9. Connector system according to claim 8 characterized in that each contact element has a flat base section (3; 6) and the connecting portions (5) are formed as flat connecting tongues integral with the base section, each said connecting tongues located at an edge of the base section.

10. Connector system according to claim 9 characterized in that the free end (12) of the connecting tongues (5) of adjacent contact elements in a column extend on one side of the plane over different distances from said one side (22) of the housing (13).

11. Connector system according to any of the preceding claims characterized in that the pitch distance between adjacent contact elements is 2 mm.

12. Connector system according to any of the preceding claims characterized in that the thickness of the side walls (15, 16) of the housing (13) is equal to or less than one-half the pitch distance between adjacent contact elements in a row.

13. Connector system according to any of the preceding claims characterized in that the contact portion (4) of the contact elements is a contact pin.

14. Connector system according to claim 13 characterized in that the contact pin (4) of at least one of the contact elements in a column has a length different than the contact pins (4) of the other contact elements in the same column.

15. Connector system according to any of the claims 1 to 12 characterized in that the contact portion (7, 8) of the contact elements is female-shaped.

16. Connector system according to claim 15 characterized in that each said female-shaped contact element comprises two resilient contact fingers (7, 8) projecting from the flat base section (6) with contact surfaces located at the free ends thereof, the contact fingers extending symmetrically relative to a center line in the longitudinal direction of the contact element and, at the end connected to the flat base section (6), being bent out of the plane of the base section over a portion of their length in opposite directions, the two contact fingers (7, 8) being bent towards each other again at the end of this portion so that the contact surfaces are located opposite each other.

17. Connector system according to any of the preceding claims characterized in that the protective plate (27, 28) is made of plastic.

18. Connector system according to any of the claims 1 to 16 characterized in that the protective plate (27, 28) is made of electrically conductive material.

19. Connector system according to any of the claims 1 to 16 characterized in that the protective plate (27, 28) is made of plastic with an electrically conductive layer applied thereupon.

## Patentansprüche

1. Steckersystem mit einem Stecker (17) und mit wenigstens einer Schutzplatte (27, 28), wobei der Stecker (17) dafür ausgebildet ist, um an einer gedruckten Leiterplatte (1, 2) befestigt zu werden, mit einem Gehäue (13) aus einem elektrisch isolierendem Material, einer Vielzahl von Kontaktelementen, die in dem Gehäuse (13) in Form von Reihen und Spalten angeordnet sind, wobei die Reihen im wesentlichen parallel zur Leiterplatte (1, 2) angeordnet sind und die Spalten im wesentlichen quer zur Leiterplatte angeordnet sind und wobei jedes der Kontaktelemente einen Basisabschnitt (3; 6) mit einem Kontaktabschnitt (4; 7, 8) und einem Verbindungsabschnitt (5) besitzt, der sich von gegenüberliegenden Seiten des Basisabschnitts aus erstreckt, wobei sich der Verbindungsabschnitt (5) von einer Seite (22) des Gehäuses (13), die zu der Leiterplatte hinweist, weg erstreckt und dafür ausgebildet ist, um an Kontaktflächen (10, 11) auf der Leiterplatte befestigt zu werden,und wobei die Verbindungsabschnitte von benachbarten Kontaktelementen in der gleichen Spalte in Richtung der Reihe derart versetzt sind, daß sie Flächen auf der gedruckten Leiterplatte, die relativ zueinander versetzt sind, kontaktieren, dadurch gekennzeichnet, daß eine Seite (22) des Gehäuses (13) wenigstens eine Reihe von Öffnungen aufweist, und daß das Steckersystem wenigstens eine Schutzplatte (27, 28) aufweist, die Zähne (30) besitzt, die entlang von wenigstens einer ihrer Kanten angeordnet sind und wobei die Zähne dafür ausgebildet sind, um sie in eine Reihe der Öffnungen in dem Gehäuse (13) des Steckers so einzuschieben, daß dann, wenn der Zusammenbau und Anschluß an die gedruckte Leiterplatte erfolgt ist, sich die Schutzplatte (27, 28) parallel zu der gedruckten Leiterplatte erstreckt.

2. Steckersystem nach Anspruch 1, dadurch gekennzeichnet, daß die Zähne (30) an einer länglichen Schiene (29) des elektrisch isolierenden Materials ausgebildet sind, wobei die Schiene nahe der Kante der Schutzplatte (27, 28) angeordnet ist und wobei die Zähne in einem Abstand von der Oberfläche der Schutzplatte angeordnet sind.

3. Steckersystem nach Anspruch 2, dadurch gekennzeichnet, daß die Schutzplatte (27, 28) sich auf beiden Seiten der länglichen Schiene (29) erstreckt.

4. Steckersystem nach irgendeinem der vorhergehenden Ansprüche, dadurch gekennzeichnet, daß die Schutzplatte (27, 28) Öffnungen (34) aufweist, die in der Ebene der Platte ausgebildet sind, wobei die Öffnungen dazu dienen, um die Schutzplatte an der gedruckten Leiterplatte (1, 2) zu befestigen.

5. Steckersystem nach irgendeinem der vorhergehenden Ansprüche, dadurch gekennzeichnet, daß die Verbindungsabschnitte (5) der Kontaktelemente in der Richtung einer Ebene geneigt sind, die sich quer zu einer Seite (22) des Gehäuses (13) in Längsrichtung desselben erstreckt, wobei die Verbindungsabschnitte (5) eine oder beide Seiten der in der Ebene angeordneten gedruckten Leiterplatte (1, 2) kontaktieren können.

6. Steckersystem nach Anspruch 5, dadurch gekennzeichnet, daß jeder Verbindungsabschnitt (5) nahe seinem freien Ende einen flachen Abschnitt (9) besitzt, der parallel zu der genannten Ebene verläuft, um eine flächenmäßige Befestigung an der gedruckten Leiterplatte (1, 2) zu erlauben.

7. Steckersystem nach Anspruch 6, dadurch gekennzeichnet, daß das freie Ende (12) jedes Verbindungsabschnitts (5) relativ zu der genannten Ebene rückwärts gebogen ist, um einen Trichter zur unmittelbaren Aufnahme der gedruckten Leiterplatte (1, 2) zu bilden.

8. Steckersystem nach Anspruch 5, dadurch gekennzeichnet, daß die Kontaktelemente in vier Reihen angeordnet sind, wobei zwei der Reihen der Kontaktelemente auf einer Seite der genannten Ebene und zwei der Reihen auf der anderen Seite der genannten Ebene angeordnet sind und wobei die Verbindungsabschnitte (5) benachbarter Kontaktelemente in der gleichen Spalte auf jeder Seite der Ebene zueinander versetzt sind.

9. Steckersystem nach Anspruch 8, dadurch gekennzeichnet, daß jedes Kontaktelement einen flachen Basisabschnitt (3; 6) besitzt, und daß die Verbindungsabschnitte (5) als flache Verbindungszungen einstückig mit dem Basisabschnitt ausgebildet sind, wobei jede der Verbindungszungen an einem Rand des Basisabschnitts gelegen ist.

10. Steckersystem nach Anspruch 9, dadurch gekennzeichnet, daß sich das freie Ende (12) der Verbindungszungen (5) von benachbarten Kontaktelementen in einer Spalte auf einer Seite der Ebene über verschiedene Abstände von der einen Seite (22) des Gehäuses (13) erstreckt.

11. Steckersystem nach irgendeinem der vorhergehenden Ansprüche, dadurch gekennzeichnet, daß der Teilungsabstand zwischen benachbarten Kontaktelementen gleich 2 mm ist.

12. Steckersystem nach irgendeinem der vorhergehenden Ansprüche, dadurch gekennzeichnet, daß die Dicke der Seitenwände (15, 16) des Gehäuses (13) gleich ist oder geringer ist als eine Hälfte des Teilungsabstandes zwischen benachbarten Kontaktelementen in einer Reihe.

13. Steckersystem nach irgendeinem der vorhergehenden Ansprüche, dadurch gekennzeichnet, daß der Kontaktabschnitt (4) der Kontaktelemente ein Kontaktstift ist.

14. Steckersystem nach Anspruch 13, dadurch gekennzeichnet, daß der Kontaktstift (4) von wenigstens einem der Kontaktelemente in einer Spalte eine Länge besitzt, die verschieden ist von derjenigen der Kontaktstifte (4) der anderen Kontaktelemente in der gleichen Spalte.

15. Steckersystem nach irgendeinem der Ansprüche 1 bis 12, dadurch gekennzeichnet, daß der Kontaktabschnitt (7, 8) der Kontaktelemente als Mutterstecker gestaltet ist.

16. Steckersystem nach Anspruch 15, dadurch gekennzeichnet, daß jedes als Mutterstecker gestaltete Kontaktelement zwei nachgiebige Kontaktfinger (7, 8) aufweist, die von dem flachen Basisabschnitt (6) abstehen, wobei Kontakfflächen an den freien Enden derselben gelegen sind, und wobei sich die Kontaktfinger symmetrisch relativ zu einer Mittellinie in Längsrichtung des Kontaktelements erstrecken und an dem Ende, welches mit dem flachen Basisabschnitt (6) verbunden ist, aus der Ebene des Basisabschnitts heraus über einen Abschnitt deren Länge in entgegengesetzte Richtungen gebogen sind, wobei die zwei Kontaktfinger (7, 8) an dem Ende dieses Abschnitts wieder aufeinander zu gebogen sind, so daß die Kontaktflächen einander gegenüberliegend angeordnet sind.

17. Steckersystem nach irgendeinem der vorhergehenden Ansprüche, dadurch gekennzeichnet, daß die Schutzplatte (27, 28) aus Kunststoff hergestellt ist.

18. Steckersystem nach irgendeinem der Ansprüche 1 bis 16, dadurch gekennzeichnet, daß die Schutzplatte (27, 28) aus einem elektrisch leitenden Material hergestellt ist.

19. Steckersystem nach irgendeinem der Ansprüche 1 bis 16, dadurch gekennzeichnet, daß die Schutzplatte (27, 28) aus Kunststoff mit einer darauf aufgebrachten elektrisch leitenden Schicht hergestellt ist.

## Revendications

1. Système de connecteur comprenant un connecteur (17) et au moins une plaque de protection (27, 28), le connecteur (17) étant apte à être monté sur une carte à circuit imprimé (1, 2) comprenant un boîtier (13) en matériau électriquement isolant, une pluralité d'éléments de contact disposés dans ledit boîtier (13), en rangées et colonnes, lesdites rangées étant disposées de façon sensiblement parallèle à la carte à circuit imprimé (1, 2) et ladite colonne étant disposée de façon sensiblement transversale à la carte à circuit imprimé, chacun desdits éléments de contact comprenant une section de base (3; 6) munie d'une partie de contact (4; 7, 8) et d'une partie de connexion (5) s'étendant à partir des côtés opposés de ladite section de base, la partie de connexion (5) étant en saillie à partir d'un côté (22) du boîtier (13) faisant face à la carte à circuit imprimé et susceptible d'être montée sur des surfaces de contact (10, 11) de ladite carte à circuit imprimé, les parties de connexion des éléments de contact adjacents de la même colonne étant déplacées dans la direction de la rangée de manière à venir en contact avec les surfaces de ladite carte à circuit imprimé décalées l'une par rapport à l'autre, caractérisé en ce que ledit côté (22) du boîtier (13) comprend au moins une rangée d'ouvertures et en ce que le système de connecteur comprend, au moins une plaque de protection (27, 28) pourvue de dents (30) disposées le long d'au moins l'un de ses bords, lesdites dents étant agencées pour être insérées dans ladite rangée d'ouvertures du boîtier (13) du connecteur, de telle manière que lorsqu'elle est assemblée et relié à la carte à circuit imprimé, la plaque de protection (27, 28) s'étende parallèlement à ladite carte à circuit imprimé.

2. Système de connecteur selon la revendication 1, caractérisé en ce que lesdites dents (30) sont formées sur un rail allongé (29) en matériau électriquement isolant, ledit rail étant disposé près dudit bord de la plaque de protection (27, 28), les dents étant disposées à distance de la surface de la plaque de protection.

3. Système de connecteur selon la revendication 2, caractérisé en ce que ladite plaque de protection (27, 28) s'étend des deux côtés du rail allongé (29).

4. Système de connecteur selon l'une quelconque des précédentes revendications, caractérisé en ce que ladite plaque de protection (27, 28) comprend en outre des ouvertures (34) formées dans le plan de la plaque, lesdites ouvertures étant adaptées pour fixer la plaque de protection sur la carte à circuit imprimé (1, 2).

5. Système de connecteur selon l'une quelconque des précédentes revendications, caractérisé en ce que les parties de connexion (5) desdits éléments de contact sont inclinées dans la direction d'un plan s'étendant transversalement audit côté (22) du boîtier (13), dans la direction longitudinale de celui-ci, lesdites parties de connexion (5) étant aptes à contacter l'une ou les deux faces de la carte à circuit imprimé (1, 2) disposée selon ce plan.

6. Système de connecteur selon la revendication 5, caractérisé en ce que chaque partie de connexion (5) comprend, à proximité de son extrémité libre, une partie plate (9) située parallèlement audit plan pour permettre un montage en surface sur la carte à circuit imprimé (1, 2).

7. Système de connecteur selon la revendication 6, caractérisé en ce que l'extrémité libre (12) de chaque partie de connexion (5) est recourbée vers l'arrière par rapport audit plan pour former une goulotte pour recevoir facilement la carte à circuit imprimé (1, 2).

8. Système de connecteur selon la revendication 5, caractérisé en ce que les éléments de contact sont disposés en quatre rangées, deux desdites rangées d'éléments de contact étant disposées d'un côté dudit plan et deux desdites rangées étant disposées sur ledit autre côté dudit plan, les parties de connexion (5) des éléments de contact adjacents de la même colonne étant déplacées mutuellement de chaque côté du plan.

9. Système de connecteur selon la revendication 8, caractérisé en ce que chaque élément de contact comprend une section de base plate (3; 6) et que les parties de connexion (5) sont réalisées en forme de languettes de connexion plates intégrées monobloc à la section de base, chacune desdites languettes de connexion étant située sur un bord de la section de base.

10. Système de connecteur selon la revendication 9, caractérisé en ce que les extrémités libres (12) des languettes de connexion (5) des éléments de contact adjacents d'une colonne s'étendent d'un côté du plan, sur des distances différentes dudit côté (22) du boîtier (13).

11. Système de connecteur selon l'une quelconque des précédentes revendications, caractérisé en ce que le pas entre les éléments de contact adjacents est de 2 mm.

12. Système de connecteur selon l'une quelconque des précédentes revendications, caractérisé en ce que l'épaisseur des parois latérales (15, 16) du boîtier (13) est égale ou inférieure à la moitié du pas entre les élements de contact adjacents d'une rangée.

13. Système de connecteur selon l'une quelconque des précédentes revendications, caractérisé en ce que la partie de contact (4) des éléments de contact est une broche de contact.

14. Système de connecteur selon la revendication 13, caractérisé en ce que la broche de contact (4) d'au moins l'un des éléments de contact d'une colonne a une longueur différente de celle des broches de contact (4) des autres éléments de contact de la même colonne.

15. Système de connecteur selon l'une quelconque des revendications 1 à 12, caractérisé en ce que la partie de contact des éléments de contact est de forme femelle.

16. Système de connecteur selon la revendication 15, caractérisé en ce que chacun desdits éléments de contact de forme femelle comprend deux doigts de contact élastiques (7, 8) en saillie à partir de la partie de base plate (6), avec des surfaces de contact situées à leurs extrémités libres, les doigts de contact s'étendant symétriquement par rapport à un axe central, dans la direction longitudinale de l'élément de contact et, à l'extrémité reliée à la section de base plate (6) sont repliés au dehors du plan de la section de base sur une partie de leur longueur, dans des directions opposées, les deux doigts de contact (7, 8) étant repliés à nouveau l'un vers l'autre à l'extrémité de cette partie, de manière que les surfaces de contact soient situées en opposition l'une par rapport à l'autre.

17. Système de connecteur selon l'une quelconque des précédentes revendications, caractérisé en ce que la plaque de protection (27, 28) est réalisée en matière plastique.

18. Système de connecteur selon l'une quelconque des revendications 1 à 16, caractérisé en ce que la plaque de protection (27, 28) est réalisée en matériau électriquement conducteur.

19. Système de connecteur selon l'une quelconque des revendications 1 à 16, caractérisé en ce que la plaque de protection (27, 28) est réalisée en matière plastique sur laquelle a été appliquée une couche électriquement conductrice.
